Europäisches Patentamt

**European Patent Office**

**Office européen des brevets**

(19)

(11) Publication number: **0 178 995**
A2

(12)

# EUROPEAN PATENT APPLICATION

(21) Application number: **85401995.7**

(22) Date of filing: **15.10.85**

(51) Int. Cl.⁴: **H 01 L 29/40**
**H 01 L 21/285**

(30) Priority: **18.10.84 JP 217398/84**

(43) Date of publication of application:
**23.04.86 Bulletin 86/17**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Inoue, Minoru**
**Hainesu Mizonokuchi 213 418-1, Hisamoto**
**Takatsu-ku Kawasaki-shi Kanagawa 213(JP)**

(74) Representative: **Descourtieux, Philippe et al,**
**CABINET BEAU de LOMENIE 55 rue d'Amsterdam**
**F-75008 Paris(FR)**

(54) **Aluminium metallized layer formed on silicon wafer.**

(57) An aluminum metallized layer formed on a silicon wafer, wherein the metallized layer is an aluminum alloy consisting essentially of 0.05% to 5.0% by weight of at least one element selected from the group of zirconium, molybdenum, tungsten, titanium, vanadium, chromium, and phosphor, 1.0% to 3,0% by weight of silicon, and the rest aluminum.

Fig. 1

EP 0 178 995 A2

ALUMINUM METALLIZED LAYER FORMED ON SILICON WAFER

BACKGROUND OF THE INVENTION

1.   Field of the Invention

The present invention relates to an aluminum metallized layer, which eliminates disadvantages inherent to conventional aluminum metallized layers formed on a silicon wafer.

2.   Description of the Related Art

In the process of producing an aluminum metallized layer on a silicon wafer, first, windows are opened through an insulating layer formed on P-N junction areas of the silicon wafer, then, aluminum is metallized thereon by a sputtering process and is patterned by dry etching.   In addition, a passivation layer is formed on the patterned aluminum layer by chemical vapor deposition of phosphosilicate glass (PSG).

When the silicon wafer is subjected to a thermal treatment of 400°C to 500°C in the wafer processing, such as the formation of a passivation layer, a certain amount of silicon and aluminum dissolve into each other.

The bulky insulating layer forms an edge at the periphery of the window.   Consequently, structural strain occurs in the portion of silicon underlying the edge of the insulating layer.   The aluminum invades the diffused areas of silicon, particularly at the portion having structural strain, to form so called spikes, which lead to breakage of the P-N junction in the diffused areas.   In order to prevent such defects, it has been known to add 1.0% to 2.0% by weight of silicon in the aluminum of the metallized layer.   If an amount more than 2.0% by weight of silicon is added to the aluminum, the oversaturated silicon precipitates, after cooling.   These precipitates form a layer of silicon containing aluminum atoms on the N-type contact area of the wafer.   The precipitates act as a P-type conductor, and, thus, a parasitic P-N junction is formed at the boundary of the metallized layer of aluminum and the diffused areas of silicon to increase the contact resistance, and relatively large silicon particles are formed within the aluminum layer, remaining even after the dry etching in patterning of the aluminum.

On the other hand, when a PSG passivation layer is deposited, as the coefficient of thermal expansion of aluminum is larger than that of PSG, thermal strain accumulates in the aluminum, and hillocks of aluminum extrude through the PSG layer during repeated thermal treatment in the wafer processing, reducing the moisture resistance of the passivation layer. This is because the structural strain in the aluminum grain boundary is relatively large due to the large size of the aluminum grains. In addition, the silicon particles grown in the aluminum grain boundary is too large in size to be completely removed by dry etching of the aluminum layer.

It has been also known to use metals other than aluminum, in the form of silicide, such as tungsten silicide, as a conductor on a silicon wafer. However, these silicides have demerits of high electric resistance and difficult aluminum wire bonding.

SUMMARY OF THE INVENTION

It is an object of the present invention to prevent an increase of the contact resistance due to the formation of a parasitic P-N junction.

It is another object of the present invention to remove precipitated silicon particles during the dry etching of the aluminum.

It is still another object of the present invention to prevent destruction of the underlying diffused areas of silicon due to the formation of spikes of aluminum therein.

It is yet another object of the present invention to prevent deterioration of a passivation layer in moisture resistance due to extruding hillocks of aluminum therethrough.

In one aspect of the present invention, there is provided an aluminum metallized layer formed on a silicon wafer, wherein the metallized layer is an aluminum alloy consisting essentially of 0.05% to 5.0% by weight of at least one element selected from the group of zirconium, molybdenum, tungsten, titanium, vanadium, chromium, and phosphor, 1.0% to 3.0% by weight of silicon, and the rest aluminum.

In another aspect of the present invention, there is provided a process for producing an aluminum metallized layer formed on a silicon wafer, wherein the metallized layer is formed by a sputtering process using a target of aluminum alloy, the aluminum alloy consisting essentially of 0.05% to 5.0% by weight of at least one element selected from the group of zirconium, molybdenum, tungsten, titanium, vanadium, chromium, and phosphor, 1.0% to 3.0% by weight of silicon, and the rest aluminum.

BRIEF DESCRIPTION OF THE DRAWING

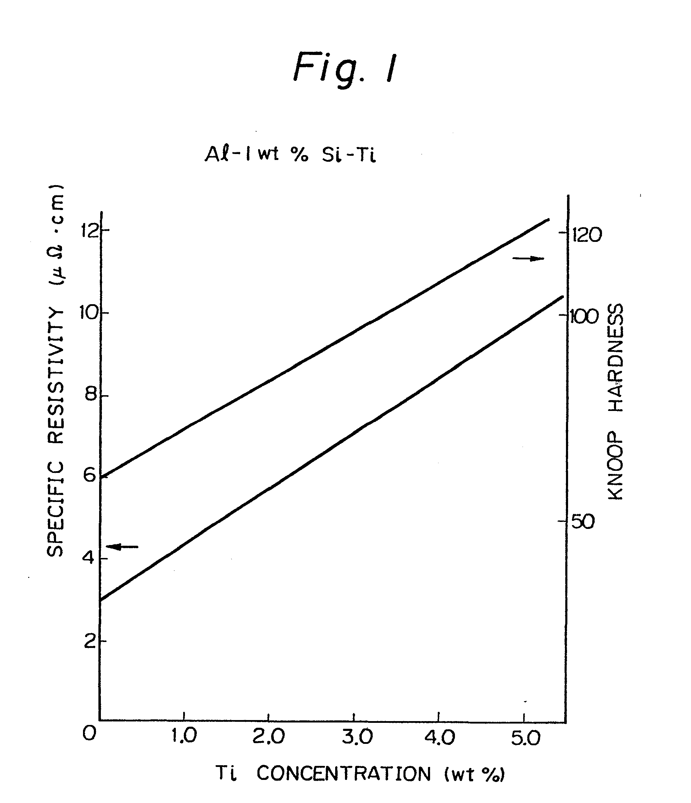

Figure 1 shows the relationship between the amount of titanium and the specific resistivity and Knoop hardness.

DESCRIPTION OF THE PREFERRED EMBODIMENTS

If an amount of more than 5.0% by weight of at least one of zirconium, molybdenum, tungsten, titanium, vanadium, molybdenum, chromium, or phosphor is contained in the aluminum alloy, the specific resistivity of the metallized layer increases to more than 10 $\mu\Omega \cdot cm$, and the Knoop hardness increases more than 120, so that bonding of aluminum wire becomes difficult. If the aluminum alloy contains less than 0.05% by weight of one or more of these elements, it is not possible to effectively reduce the grain size of the aluminum, so that it is difficult to prevent hillocks and to improve the contact characteristics. Figure 1 shows the

- 4 -                                    0178995

relationship between the amount of titanium and the specific resistivity and Knoop hardness.

The sputtering temperature can be raised up to 300°C without extrusion of aluminum hillocks, contrary to the conventional sputtering temperature of 250°C, to obtain a better step coverage of the mettalized aluminum layer.

It is, of course, possible to prevent invasion of aluminum spikes through the diffused areas of the silicon wafer, when zirconium, molybdenum, tungsten, titanium, vanadium, and phosphor coexist with silicon in the metallized aluminum. Each of these coexisting elements reacts with silicon to form a silicide, such as $ZrSi_2$. Thus, it is possible to increase the amount of silicon up to 3.0% by weight in the aluminum without increasing the number of silicon precipitates in the grain boundary of the aluminum.

On the other hand, each of these elements exhibits poor solid solubility in aluminum. Thus, such elements tend to form a peritectic alloy with aluminum, which encloses the primary crystal and refines the aluminum grain size. Because the grain size of aluminum is small, the structural strain in its grain boundary is easily released during thermal treatment, and the extrusion of hillocks is reduced through the passivation layer. In addition, silicon precipitates formed in the grain boundary have also relatively small size, due to the small aluminum grain size. Thus, the remaining silicon residues are reduced after patterning of the aluminum by dry etching.

The advantage of the present invention will be clearly understood by the following example, which illustrates an embodiment of the present invention, but does not limit the scope thereof.

Example

An aluminum alloy was metallized on a silicon wafer having windows opened at the diffused junction areas by a sputtering process, in which the target was an alloy containing 1% by weight of titanium, 1% by weight of silicon, and the rest aluminum, the silicon wafer was heated at about 300°C, the distance of the wafer from the target was 5 to 10 cm, the pressure of argon was kept at 2 to 7 Torr (about 3 to 9 mbar), and about 7 kW of power was applied.

The step coverage of the metallized aluminum layer was desirable due to the higher temperature of the wafer during sputtering. Almost no residues were observed after patterning the metallized aluminum layer by dry etching in an atmosphere of carbon tetrachloride.

A PSG passivation layer was deposited on the patterned aluminum by chemical vapor deposition using silane, phosphine, and oxygen diluted in hydrogen at a temperature of 450°C. No hillocks extruded up to the surface of the passivation layer.

- 6 -

0178995

## CLAIMS

1. An aluminum metallized layer formed on a silicon wafer, wherein said metallized layer is an aluminum alloy consisting essentially of 0.05% to 5.0% by weight of at least one element selected from the group of zirconium, molybdenum, tungsten, titanium, vanadium, chromium, and phosphor, 1.0% to 3.0% by weight of silicon, and the rest aluminum.

2. A process for producing an aluminum metallized layer formed on a silicon wafer, wherein said metallized layer is formed by a sputtering process using a target of aluminum alloy, said aluminum alloy consisting essentially of 0.05% to 5.0% by weight of at least one element selected from the group of zirconium, molybdenum, tungsten, titanium, vanadium, chromium, and phosphor, 1.0% to 3.0% by weight of silicon, and the rest aluminum.

# Fig. I

Al-I wt % Si-Ti